# EUROPEAN PATENT APPLICATION

(11) **EP 4 679 562 A1**
(43) Date of publication of application: **14.01.2026**
(21) Application number: 25187948.2
(22) Date of filing: 07.07.2025
(51) Int. Cl.: H01M 10/48

(54) **WIRELESS BATTERY MANAGEMENT SYSTEM, BATTERY PACK COMPRISING THE SAME, AND APPARATUS COMPRISING THE BATTERY PACK**

(30) Priority: 10.07.2024 KR 20240091198
(71) Applicant: SK On Co., Ltd., Seoul 03161 (KR)
(72) Inventor: LEE, Chang Joo, 34124 Daejeon (KR)
(74) Representative: Prüfer & Partner mbB Patentanwälte · Rechtsanwälte

(57) **Abstract**

Wireless battery management systems, battery packs, and apparatuses comprising the battery packs are disclosed. In an embodiment, a wireless battery management system may include a plurality of wireless electrochemical impedance spectroscopy (EIS) modules configured to connect to a respective battery module of a plurality of battery modules included in a battery pack and measure EIS of the respective battery module; and a first wireless battery management module configured to communicatively couple wirelessly with the plurality of wireless EIS modules, receive EIS measurement results wirelessly from the plurality of wireless EIS modules, and manage the plurality of battery modules based on the received EIS measurement results.

## Description

### CROSS-REFERENCE TO RELATED APPLICATION

This patent document claims the priority and benefits of Korean Patent Application No. 10-2024-0091198 filed July 10, 2024, the disclosure of which is incorporated herein by reference in its entirety.

### TECHNICAL FIELD

The disclosed technology relates to a wireless battery management system, a battery pack comprising the same, and an apparatus comprising the battery pack.

### BACKGROUND

Secondary batteries, which are rechargeable batteries capable of repeated charging and discharging, are widely used as power sources for portable electronic communication devices such as camcorders, mobile phones, tablet personal computers (PCs), and laptop PCs. This widespread use is driven by advancements in the information communication and display industries. Recently, battery packs including a plurality of battery modules have been developed for use as power sources for eco-friendly vehicles, such as electric vehicles (EVs).

Such battery packs may include a battery management system (BMS) that monitors and manages the state of the battery modules such as voltage, current, and temperature. The BMS may include slave BMS units, each located in each battery module, and a master BMS unit that communicates with the slave BMSs and centrally manages the plurality of battery modules.

Recently, approaches for monitoring and managing the state of battery modules based on Electrochemical Impedance Spectroscopy (EIS) have been actively researched and developed. As a result, an increasing number of battery packs now include EIS modules.

### SUMMARY

The disclosed technology can be implemented in some embodiments to provide a wireless battery management system, a battery pack comprising the same, and an apparatus comprising the battery pack, thereby improving manufacturing process efficiency.

The disclosed technology can be implemented in some embodiments to provide a wireless battery management system, a battery pack comprising the same, and an apparatus comprising the battery pack, thereby improving power efficiency.

The disclosed technology can be implemented in some embodiments to provide a wireless battery management system, a battery pack comprising the same, and an apparatus comprising the battery pack, thereby improving space efficiency.

The wireless battery management system and/or the battery pack comprising the same based on the disclosed technology may be widely applied in green technology fields, such as electric vehicles (EVs), battery charging stations, and other battery-powered applications including solar power generation and wind power generation. Furthermore, the wireless battery management system and the battery pack comprising the wireless battery management system implemented based on some embodiments of the disclosed technology may be used in eco-friendly applications such as Electric Vehicles (EVs) and hybrid vehicles (HVs), which contribute to mitigating climate change by suppressing air pollution and greenhouse gas emissions.

Various advantages and effects beyond those described above may be realized through embodiments of the disclosed technology.

In some non-limiting embodiments or aspects of the disclosed technology, a wireless battery management system comprises: a plurality of wireless electrochemical impedance spectroscopy (EIS) modules, each wireless EIS module coupled to a respective one of a plurality of battery modules included in a battery pack, and configured to generate EIS measurement results by measuring EIS of the respective one of the plurality of battery modules; and a first wireless battery management module communicatively coupled wirelessly to the plurality of wireless EIS modules and configured to manage the plurality of battery modules based on the EIS measurement results received wirelessly from the plurality of wireless EIS modules.

In some non-limiting embodiments or aspects, the first wireless battery management module comprises: a first battery management module configured to manage a state of the plurality of battery modules; and a first wireless communication module coupled to the first battery management module, and each of the plurality of wireless EIS modules comprises: an EIS module configured to measure EIS of the respective one of the plurality of battery modules; and a second wireless communication module coupled to the EIS module and configured to wirelessly communicate with the first wireless communication module.

In some non-limiting embodiments or aspects, the wireless battery management system further comprises: a plurality of second wireless battery management modules, each second wireless battery management module coupled to a respective one of the plurality of battery modules and configured to monitor and manage a state of the respective one of the plurality of battery modules.

In some non-limiting embodiments or aspects, each of the plurality of second wireless battery management modules comprises: a second battery management module configured to measure and monitor a state of the respective battery module; and a third wireless communication module coupled to the second battery management module and configured to wirelessly communicate with the first wireless communication module.

In some non-limiting embodiments or aspects, the first wireless battery management module is configured to: wirelessly transmit, to each of the plurality of wireless EIS modules, an activation signal to request activation of at least one wireless EIS module connected to at least one battery module requiring management; and wirelessly transmit, to each of the plurality of wireless EIS modules, a deactivation signal upon completion of impedance measurement of the at least one battery module requiring management.

In some non-limiting embodiments or aspects, each wireless EIS module of the plurality of wireless EIS modules is configured to: measure impedance of the respective battery module upon receiving the activation signal; and transmit the measured impedance wirelessly to the first wireless battery management module.

In some non-limiting embodiments or aspects, each of the plurality of wireless EIS modules is detachably coupled to a respective one of the plurality of battery modules.

In some non-limiting embodiments or aspects of the disclosed technology, a battery pack comprises: a plurality of battery modules, each battery module comprising a plurality of battery cells; and a wireless battery management system configured to manage the plurality of battery modules, wherein the wireless battery management system comprises: a plurality of wireless electrochemical impedance spectroscopy (EIS) modules, each wireless EIS module coupled to a respective one of the plurality of battery modules and configured to generate EIS measurement results by measuring EIS of the respective one of the plurality of battery modules; and a first wireless battery management module communicatively coupled wirelessly to the plurality of wireless EIS modules and configured to manage the plurality of battery modules based on the EIS measurement results received wirelessly from the plurality of wireless EIS modules.

In some non-limiting embodiments or aspects, the battery pack further comprises: a plurality of second wireless battery management modules, each second wireless battery management module coupled to a respective one of the plurality of battery modules and configured to monitor and manage a state of the respective battery module.

In some non-limiting embodiments or aspects, the battery pack further comprises: a communication module configured to communicate with a battery-powered device configured to operate by receiving power from the battery pack.

In some non-limiting embodiments or aspects of the disclosed technology, an apparatus comprises: a battery pack comprising a wireless battery management system, wherein the wireless battery management system comprises: a plurality of wireless electrochemical impedance spectroscopy (EIS) modules, each wireless EIS module coupled to a respective one of a plurality of battery modules included in the battery pack and configured to generate EIS measurement results by measuring EIS of the respective one of the plurality of battery modules; and a first wireless battery management module communicatively coupled wirelessly to the plurality of wireless EIS modules and configured to manage the plurality of battery modules based on the EIS measurement results received wirelessly from the plurality of wireless EIS modules; a communication module configured to communicate with the wireless battery management system included in the battery pack; and a control module configured to communicate with the wireless battery management system via the communication module and control a state of the battery pack.

In some non-limiting embodiments or aspects of the apparatus, the first wireless battery management module comprises: a first battery management module configures to manage a state of the plurality of battery modules; and a first wireless communication module coupled to the first battery management module, and each of the plurality of wireless EIS modules comprises: an EIS module configured to measure EIS of the respective one of the plurality of battery modules; and a second wireless communication module coupled to the EIS module and configured to wirelessly communicate with the first wireless communication module.

In some non-limiting embodiments or aspects of the apparatus, the wireless battery management system further comprises: a plurality of second wireless battery management modules, each second wireless battery management module coupled to a respective one of the plurality of battery modules and configured to monitor and manage a state of the respective battery module.

In some non-limiting embodiments or aspects of the apparatus, each of the plurality of second wireless battery management modules comprises: a second battery management module configured to measure and monitor a state of the respective battery module; and a third wireless communication module coupled to the second battery management module and configured to wirelessly communicate with the first wireless communication module.

In some non-limiting embodiments or aspects of the apparatus, the first wireless battery management module is configured to: wirelessly transmit, to each of the plurality of wireless EIS modules, an activation signal requesting activation of at least one wireless EIS module connected to at least one battery module requiring management; and wirelessly transmit, to each of the plurality of wireless EIS modules, a deactivation signal upon completion of impedance measurement of the at least one battery module requiring management.

In some non-limiting embodiments or aspects of the apparatus, each wireless EIS module of the plurality of wireless EIS modules is configured to: measure impedance of the respective battery module upon receiving the activation signal; and transmit the measured impedance wirelessly to the first wireless battery management module.

In some non-limiting embodiments or aspects of the apparatus, each of the plurality of wireless EIS modules is detachably coupled to a respective one of the plurality of battery modules.

In some non-limiting embodiments or aspects, the efficiency of the manufacturing process can be improved. For example, since components of the battery management system (e.g., BMU, CMU, EIS module, etc.) are wirelessly connected, a complex manufacturing process of wiring these components may be omitted. Consequently, the manufacturing process can be simplified, manufacturing costs can be reduced, and maintenance convenience can be enhanced.

In some non-limiting embodiments or aspects, power efficiency can be improved. For example, by eliminating the wires between the components of the battery management system, the weight and/or size of the battery pack can be reduced. Consequently, the power efficiency and space efficiency of the battery pack can be improved.

In some non-limiting embodiments or aspects, the EIS module can be detachably coupled to the battery module, thereby improving efficiency for the battery pack manufacturer. For example, during manufacturing, the manufacturer can easily detect defects or faults by mounting a wireless EIS module on at least one battery module. Furthermore, the manufacturer can offer flexibility by selling the battery pack with the EIS module either maintained or removed according to a purchaser's request.

These and other features and characteristics of the disclosed technology, as well as methods of operation, functional relationships among structural elements, and advantages in manufacture, will become more apparent from the following description and the appended claims, with reference to the accompanying drawings. The drawings form a part of this specification and illustrate example embodiments in which like reference numerals refer to corresponding parts throughout the various figures.

### BRIEF DESCRIPTION OF THE DRAWINGS

Certain aspects, features, and advantages of the disclosed technology are illustrated by the following detailed description with reference to the accompanying drawings.
FIG. 1 illustrates a battery pack based on an embodiment of the disclosed technology.
FIG. 2 is a flowchart illustrating a method for measuring battery impedance of a wireless battery management system included in a battery pack, based on an embodiment of the disclosed technology.
FIG. 3 illustrates a configuration of an apparatus comprising a battery pack based on an embodiment of the disclosed technology.
FIG. 4 illustrates an electric vehicle comprising a battery pack based on an embodiment of the disclosed technology.

### DETAILED DESCRIPTION

Hereinafter, example embodiments of the disclosed technology will be described in detail with reference to the accompanying drawings. It should be understood, however, these embodiments are provided by way of example only are not intended to limit the scope of the disclosed technology to the specific embodiments.

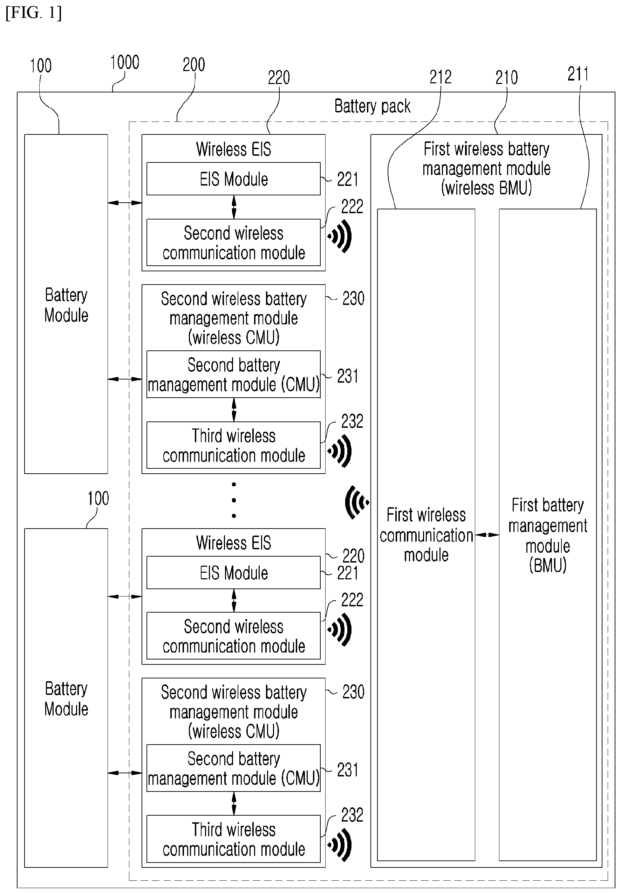

FIG. 1 illustrates a battery pack based on an embodiment of the disclosed technology.

Referring to FIG. 1, a battery pack 1000 based on an embodiment of the disclosed technology may include a plurality of battery modules 100 and a wireless battery management system (BMS) 200.

The plurality of battery modules 100 may be located (e.g., mounted) inside the battery pack 1000. For example, the plurality of battery modules 100 may be secured inside the battery pack 1000 using a fixture (e.g., a tray). Each of the plurality of battery modules 100 may be formed by stacking a plurality of battery cells (not shown). Here, each battery cell may include a positive electrode, a positive active material, a negative electrode, a negative active material, and an electrolyte.

The wireless battery management system 200 may include a first wireless battery management module 210, a plurality of wireless electrochemical impedance spectroscopy (EIS) modules 220, and a plurality of second wireless battery management modules 230.

The first wireless battery management module 210 may monitor and integrally manage the state (e.g., voltage, current, temperature, State Of Charge (SOC), State Of Health (SOH), overcharge, overdischarge) of the plurality of battery modules 100 using wireless communication. For example, the first wireless battery management module 210 may be wirelessly connected to the plurality of wireless EIS modules 220 and/or the plurality of second wireless battery management modules 230, and may integrally manage the plurality of battery modules 100 based on EIS measurement results received wirelessly from the plurality of wireless EIS modules 220 and/or state information (e.g., voltage, current, temperature) received wirelessly from the plurality of second wireless battery management modules 230. The first wireless battery management module 210 may function as a wireless battery management unit (BMU). The first wireless battery management module 210 may be included (e.g., mounted or embedded) in a battery protection unit (BPU) (not shown) that protects the battery pack 1000 by cutting off current, switching charge/discharge modes, and/or monitoring voltage, current, and temperature.

The first wireless battery management module 210 may include a first battery management module 211 and a first wireless communication module 212. The first battery management module 211 may integrally manage the state of the plurality of battery modules 100. The first battery management module 211 may be, but is not limited to, a controller (e.g., a battery management unit (BMU), a micro control unit (MCU), a micro processor unit (MPU)). The first wireless communication module 212 may perform wireless communication with the plurality of wireless EIS modules 220 and/or the plurality of second wireless battery management modules 230. The wireless communication may be short-range wireless communication such as Bluetooth, Zigbee, Wi-Fi, etc. For example, the first wireless communication module 212 may be, but is not limited to, a Bluetooth communication module.

The plurality of wireless EIS modules 220 are respectively connected to the plurality of battery modules 100 included in the battery pack 1000, and may respectively measure the EIS of the plurality of battery modules. In an embodiment, the plurality of wireless EIS modules 220 may be respectively detachably coupled to the plurality of battery modules 100.

Each of the plurality of wireless EIS modules 220 may include an EIS module (e.g., an EIS Integrated Circuit (IC)) 221 and a second wireless communication module 222. The EIS module 221 may measure the EIS of the respective battery module (or, respectively measure the EIS of battery cells included in the respective battery module). The second wireless communication module 222 is coupled to the EIS module 221 and may perform wireless communication (e.g., Bluetooth) with the first wireless battery management module 210 (e.g., the first wireless communication module 212). For example, the second wireless communication module 222 may transmit the EIS measurement results for the respective battery module 100 measured by the EIS module 221 to the first wireless battery management module 210 via the first wireless communication module 212. In an embodiment, the second wireless communication module 222 may be, but is not limited to, a Bluetooth communication module.

The plurality of second wireless battery management modules 230 are respectively connected to the plurality of battery modules 100, and may respectively monitor and manage the state of the plurality of battery modules 100. The plurality of second wireless battery management modules 230 may be wireless Cell Monitoring (or Management) Units (CMUs). In an embodiment, the plurality of second wireless battery management modules 230 may be respectively detachably coupled to the plurality of battery modules 100.

Each of the plurality of second wireless battery management modules 230 may include a second battery management module 231 and a third wireless communication module 232. The second battery management module 231 may measure and monitor the state of the respective battery module. The second battery management module 231 may be a cell monitoring unit (CMU). The third wireless communication module 232 is coupled to the second battery management module 231 and may perform wireless communication (e.g., Bluetooth) with the first wireless battery management module 210 (e.g., the first wireless communication module 212). For example, the third wireless communication module 232 may transmit state information (e.g., voltage, current, temperature, etc.) of the respective battery module 100, detected (or measured or monitored) by the connected second battery management module 231, to the first wireless battery management module 210 via the first wireless communication module 212. In an embodiment, the third wireless communication module 232 may be, but is not limited to, a Bluetooth communication module.

Although not shown in FIG. 1, the battery pack 1000 may further include a communication module for communicating with an apparatus comprising the battery pack 1000 (e.g., an electric mobility device, an energy storage system (ESS), etc.).

The battery pack 1000 implemented based on some embodiments of the disclosed technology may simplify the manufacturing process and/or enhance maintenance convenience, as the EIS module 221 and the second battery management module (e.g., CMU) 231 are wirelessly connected. Furthermore, in the battery pack 1000 implemented based on some embodiments of the disclosed technology, maintenance may be more convenient becuase the wireless EIS module 220 and/or the second wireless battery management module 230 are detachably coupled to the battery module 100. For example, in the event of failure in the wireless EIS module 220 and/or the second wireless battery management module 230, simple repairs may be performed by replacing the failed module(s). Furthermore, in some embodiments of the disclosed technology, the operational efficiency for the manufacturer of the battery pack 1000 and/or a company receiving the battery pack 1000 (e.g., an electric vehicle manufacturer) can be improved. For example, during the manufacturing process of the battery pack, the manufacturer may mount a wireless EIS module on at least one battery module and may detect defects or faults in the battery pack 1000 through the wireless EIS module. Furthermore, the manufacturer may remove or maintain the wireless EIS module 220 according to the request of the company receiving the battery pack 1000 (e.g., the electric vehicle manufacturer). In this way, the manufacturer can easily detect defects of the battery pack 1000 using the wireless EIS module, and the receiving company can purchase the battery pack with the EIS module removed if needed, thereby reducing purchase costs.

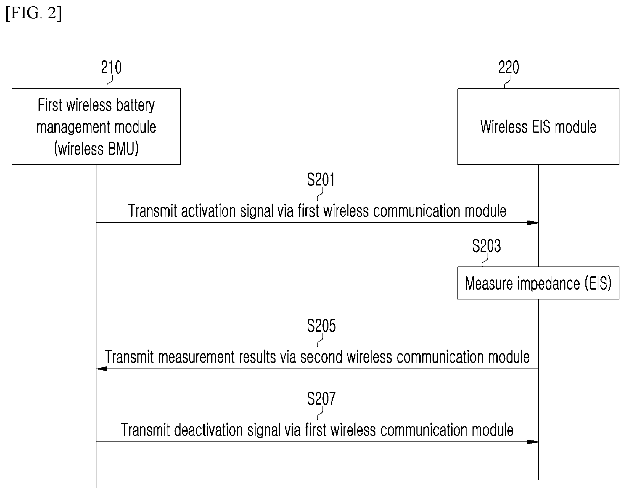

FIG. 2 is a flowchart illustrating a method for measuring battery impedance of a wireless battery management system included in a battery pack, based on an embodiment of the disclosed technology.

Referring to FIG. 2, a method (hereinafter referred to as "measurement method") for measuring battery impedance of the wireless battery management system (BMS) 200 included in a battery pack based on an embodiment of the disclosed technology may include transmitting (S210), by the first wireless battery management module 210, an activation signal to the wireless EIS module 220 via the first wireless communication module 212. For example, the first wireless communication module 212 of the first wireless battery management module 210, under the control of the first battery management module 211, may transmit the activation signal to the second wireless communication module 222 of at least one wireless EIS module 220. The activation signal may be a signal requesting activation (and/or measurement) of at least one EIS module 221 connected to at least one battery module, for the purpose of performing impedance measurement (e.g., EIS measurement) on the at least one battery module (e.g., at least one battery module requiring management).

The measurement method may include measuring (S203), impedance, by the wireless EIS module 220. For example, the at least one EIS module 221 that received the activation signal may apply a signal (e.g., a sinusoidal current signal) with a specified magnitude and a frequency that varies within a specified range (e.g., 1 Hz to 1 KHz) to the corresponding battery module, receive a voltage signal output from the corresponding battery module in response to the applied signal, and measure the impedance of the corresponding battery module based on the applied signal and the received voltage signal across the frequency range. In other words, the EIS module 221 may measure the impedance of the battery module as a function of frequency.

The measurement method may include transmitting (S205), by the wireless EIS module 220, measurement results (e.g., the measured impedance) to the first wireless battery management module 210 via the second wireless communication module 222. For example, the second wireless communication module 222 of the at least one wireless EIS module 220 may transmit the measurement results to the first wireless communication module 212 of the first wireless battery management module 210.

The measurement method may include transmitting (S207), by the first wireless battery management module 210, a deactivation signal to the wireless EIS module 220 via the first wireless communication module 212. For example, the first wireless communication module 212 of the first wireless battery management module 210, under the control of the first battery management module 211, may transmit the deactivation signal to the second wireless communication module 222 of the wireless EIS module 220 connected to the battery module for which impedance measurement is completed. The deactivation signal may be a signal requesting deactivation of the EIS module 221 for which impedance measurement is completed.

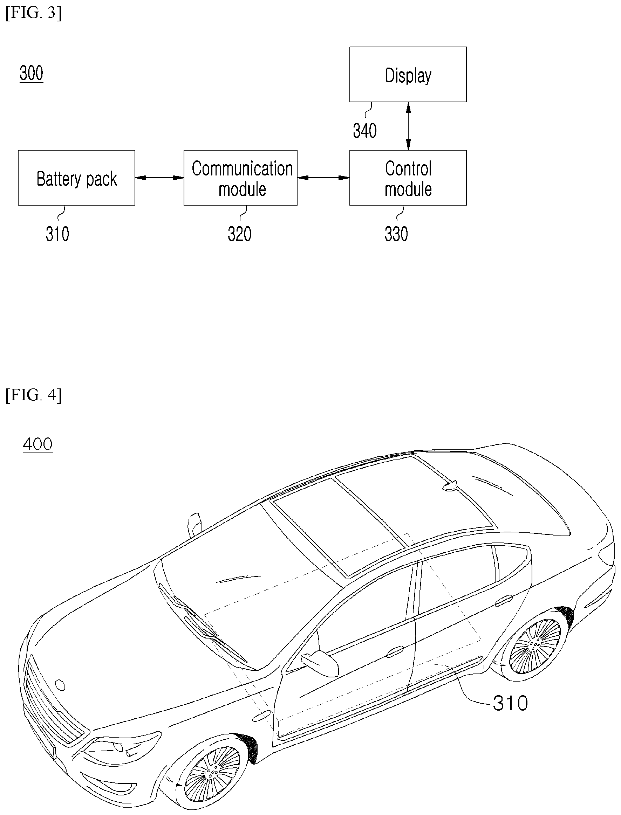

FIG. 3 is a diagram illustrating a configuration of an apparatus comprising a battery pack based on an embodiment of the disclosed technology, and FIG. 4 is a diagram illustrating an electric vehicle comprising a battery pack based on an embodiment of the disclosed technology.

Referring to FIGS. 3 and 4, an apparatus comprising a battery pack based on an embodiment of the disclosed technology (hereinafter, a battery-powered device) 300 may be powered by a battery pack 310. For example, the battery-powered device 300 may be an electric vehicle (EV) 400.

In an embodiment, the battery-powered device 300 may include a battery pack 310, a communication module 320, a control module 330, and a display 340.

The battery pack 310 may supply power (hereinafter referred to as "driving power") for driving the battery-powered device 300. For example, the battery pack 310 may supply driving power to an electric motor (not shown) of the electric vehicle 400. Furthermore, the battery pack 310 may communicate with the control module 330 via the communication module 320. Meanwhile, the battery pack 310 may be the battery pack 1000 of FIG. 1.

The communication module 320 may enable communication (e.g., connection) between the battery pack 310 (e.g., the wireless battery management system included in the battery pack 310) and the control module 330. For example, the communication module 320 may, without limitation, facilitate communication between the battery pack 310 and the control module 330 via a wired communication network (e.g., a Control Area Network (CAN)).

The control module 330 may control the overall operation of the battery-powered device 300. For example, the control module 330 may manage the distribution of power from the battery pack 310 to various components of the battery-powered device 300 (e.g., the electric motor, the display 340). Furthermore, the control module 330 may monitor and manage the state of the battery pack 310. For example, when the battery-powered device 300 is an electric vehicle 400, the control module 330 may communicate with the wireless battery management system (e.g., the first wireless battery management system 210 of FIG. 1) included in the battery pack 310 via the communication module 320, and may monitor and manage the state of the battery pack 310. In an embodiment, when the battery-powered device 300 is an electric vehicle, the control module 330 may be an Electronic Control Unit (ECU).

The display 340 may function to display various screens (e.g., still or moving images). For example, when the battery-powered device 300 is an electric vehicle, the display 340 may display information related to the operation of the electric vehicle 400 on various screens. As another example, the display 340 may output at least a portion of the state (e.g., voltage, current, SOC, SOH, etc.) of the battery pack 310 (or each battery module (not shown) included therein), received via the communication module 320, and/or an alarm (e.g., a message, an icon, etc.) indicating a fault in the battery pack 310 (or each battery module). In some embodiments, the display 340 may include a touch panel performing an input function.

While the foregoing description has illustrated an example in which the battery pack 310 is included in an electric vehicle 400 (as shown in FIG. 4), the battery pack 310 of the disclosed technology may be included in various other apparatuses. For example, the battery pack 310 may be included in an electric mobility device (e.g., a hybrid vehicle, an electric bicycle, an electric motorcycle, etc.). As another example, the battery pack 310 may be included in an energy storage system (ESS). Herein, the energy storage system (ESS) may store surplus energy in the battery pack 310, use energy stored in the battery pack 310 for operation during a power shortage, or provide the stored energy to an external device (e.g., by transmitting power to the external device).

In some embodiments, the battery-powered apparatus 300 may omit some of the above-described components, or may additionally include other components. For example, the battery-powered apparatus 300 may be configured withou the display 340. As another example, the battery-powered apparatus 300 may further include an input module for receiving user input (e.g., an operation command) and/or an alarm module (e.g., a light emitting module, a vibration motor, etc.). Alternatively, some of the components of the battery-powered apparatus 300 may be configured as separate external devices. For example, the display 340 of the battery-powered apparatus 300 may be configured as a separate external device.

The disclosed technology can be implemented in battery packs with wireless battery management for rechargeable secondary batteries that are widely used in battery-powered devices or systems, including, for battery-based power systems, hybrid vehicles, electric vehicles, uninterruptible power supplies, battery storage power stations, and others including battery power storage for solar panels, wind power generators and other green tech power generators, thereby mitigating climate changes, air pollution and greenhouse emissions.

Only specific examples of implementations of certain embodiments are described. Variations, improvements and enhancements of the disclosed embodiments and other embodiments may be made based on the disclosure of this patent document.

The invention is also defined by the following aspects:
Aspect 1. A wireless battery management system, comprising:
   a plurality of wireless electrochemical impedance spectroscopy (EIS) modules, each wireless EIS module coupled to a respective one of a plurality of battery modules included in a battery pack and configured to generate EIS measurement results by measuring EIS of the respective one of the plurality of battery modules; and
   a first wireless battery management module communicatively, wirelessly coupled to the plurality of wireless EIS modules and configured to manage the plurality of battery modules based on the EIS measurement results received wirelessly from the plurality of wireless EIS modules.
Aspect 2. The wireless battery management system of aspect 1,
   wherein the first wireless battery management module comprises:
      a first battery management module configured to manage a state of the plurality of battery modules; and
      a first wireless communication module coupled to the first battery management module,
   wherein each of the plurality of wireless EIS modules comprises:
      an EIS module configured to measure EIS of the respective one of the plurality of battery modules; and
      a second wireless communication module coupled to the EIS module and configured to wirelessly communicate with the first wireless communication module.
Aspect 3. The wireless battery management system of aspect 1 or aspect 2, further comprising:
   a plurality of second wireless battery management modules, each second wireless battery management module coupled to a respective one of the plurality of battery modules and configured to monitor and manage a state of the respective one of the plurality of battery modules,
   wherein each of the plurality of second wireless battery management modules comprises:
      a second battery management module configured to measure and monitor a state of the respective battery module; and
      a third wireless communication module coupled to the second battery management module and configured to wirelessly communicate with the first wireless communication module.
Aspect 4. The wireless battery management system of any one of aspects 1 to 3,
   wherein the first wireless battery management module is configured to:
   wirelessly transmit, to each of the plurality of wireless EIS modules, an activation signal to request activation of at least one wireless EIS module connected to at least one battery module requiring management; and
   wirelessly transmit, to each of the plurality of wireless EIS modules, a deactivation signal upon completion of impedance measurement of the at least one battery module requiring management.
Aspect 5. The wireless battery management system of aspect 4,
   wherein each wireless EIS module of the plurality of wireless EIS modules is configured to:
   measure impedance of the respective battery module upon receiving the activation signal; and
   transmit the measured impedance wirelessly to the first wireless battery management module.
Aspect 6. The wireless battery management system of any one of aspects 1 to 5,
   wherein each of the plurality of wireless EIS modules is detachably coupled to a respective one of the plurality of battery modules.
Aspect 7. A battery pack, comprising:
   a plurality of battery modules, each battery module comprising a plurality of battery cells; and
   a wireless battery management system configured to manage the plurality of battery modules,
   wherein the wireless battery management system comprises:
      a plurality of wireless electrochemical impedance spectroscopy (EIS) modules, each wireless EIS module coupled to a respective one of the plurality of battery modules and configured to generate EIS measurement results by measuring EIS of the respective one of the plurality of battery modules; and
      a first wireless battery management module communicatively, wirelessly coupled to the plurality of wireless EIS modules and configured to manage the plurality of battery modules based on the EIS measurement results received wirelessly from the plurality of wireless EIS modules.
Aspect 8. The battery pack of aspect 7, further comprising: a plurality of second wireless battery management modules, each second wireless battery management module coupled to a respective one of the plurality of battery modules and configured to monitor and manage a state of the respective battery module.
Aspect 9. The battery pack of aspect 7 or aspect 8, further comprising: a communication module configured to communicate with a battery-powered device configured to operate by receiving power from the battery pack.
Aspect 10. An apparatus, comprising:
   a battery pack comprising a wireless battery management system, wherein the wireless battery management system comprises:
   a plurality of wireless electrochemical impedance spectroscopy (EIS) modules, each wireless EIS module coupled to a respective one of a plurality of battery modules included in the battery pack and configured to generate EIS measurement results by measuring EIS of the respective one of the plurality of battery modules; and
   a first wireless battery management module communicatively, wirelessly coupled to the plurality of wireless EIS modules and configured to manage the plurality of battery modules based on the EIS measurement results received wirelessly from the plurality of wireless EIS modules;
   a communication module configured to communicate with the wireless battery management system included in the battery pack; and
   a control module configured to: communicate with the wireless battery management system via the communication module; and control a state of the battery pack.
Aspect 11. The apparatus of aspect 10,
   wherein the first wireless battery management module comprises:
      a first battery management module configured to manage a state of the plurality of battery modules; and
      a first wireless communication module coupled to the first battery management module,
   wherein each of the plurality of wireless EIS modules comprises:
      an EIS module configured to measure EIS of the respective one of the plurality of battery modules; and
      a second wireless communication module coupled to the EIS module and configured to wirelessly communicate with the first wireless communication module.
Aspect 12. The apparatus of aspect 10 or aspect 11,
   wherein the wireless battery management system further comprises:
   a plurality of second wireless battery management modules, each second wireless battery management module coupled to a respective one of the plurality of battery modules and configured to monitor and manage a state of the respective battery module,
   wherein each of the plurality of second wireless battery management modules comprises:
      a second battery management module configured to measure and monitor a state of the respective battery module; and
      a third wireless communication module coupled to the second battery management module and configured to wirelessly communicate with the first wireless communication module.
Aspect 13. The apparatus of any one of aspects 10 to 12,
   wherein the first wireless battery management module is configured to:
   wirelessly transmit, to each of the plurality of wireless EIS modules, an activation signal requesting activation of at least one wireless EIS module connected to at least one battery module requiring management; and
   wirelessly transmit, to each of the plurality of wireless EIS modules, a deactivation signal upon completion of impedance measurement of the at least one battery module requiring management.
Aspect 14. The apparatus of aspect 13,
   wherein each wireless EIS module of the plurality of wireless EIS modules is configured to:
   measure impedance of the respective battery module upon receiving the activation signal; and
   transmit the measured impedance wirelessly to the first wireless battery management module.
Aspect 15. The apparatus of any one of aspects 10 to 14,
   wherein each of the plurality of wireless EIS modules is detachably coupled to a respective one of the plurality of battery modules.

## Claims

1. A wireless battery management system, comprising:
a plurality of wireless electrochemical impedance spectroscopy (EIS) modules, each wireless EIS module coupled to a respective one of a plurality of battery modules included in a battery pack and configured to generate EIS measurement results by measuring EIS of the respective one of the plurality of battery modules; and
a first wireless battery management module communicatively, wirelessly coupled to the plurality of wireless EIS modules and configured to manage the plurality of battery modules based on the EIS measurement results received wirelessly from the plurality of wireless EIS modules.

2. The wireless battery management system of claim 1,
wherein the first wireless battery management module comprises:
a first battery management module configured to manage a state of the plurality of battery modules; and
a first wireless communication module coupled to the first battery management module,
wherein each of the plurality of wireless EIS modules comprises:
an EIS module configured to measure EIS of the respective one of the plurality of battery modules; and
a second wireless communication module coupled to the EIS module and configured to wirelessly communicate with the first wireless communication module.

3. The wireless battery management system of claims 1 or 2, further comprising:
a plurality of second wireless battery management modules, each second wireless battery management module coupled to a respective one of the plurality of battery modules and configured to monitor and manage a state of the respective one of the plurality of battery modules,
wherein each of the plurality of second wireless battery management modules comprises:
a second battery management module configured to measure and monitor a state of the respective battery module; and
a third wireless communication module coupled to the second battery management module and configured to wirelessly communicate with the first wireless communication module.

4. The wireless battery management system of any one of claims 1 to 3, wherein the first wireless battery management module is configured to:
wirelessly transmit, to each of the plurality of wireless EIS modules, an activation signal to request activation of at least one wireless EIS module connected to at least one battery module requiring management; and
wirelessly transmit, to each of the plurality of wireless EIS modules, a deactivation signal upon completion of impedance measurement of the at least one battery module requiring management.

5. The wireless battery management system of claim 4,
wherein each wireless EIS module of the plurality of wireless EIS modules is configured to:
measure impedance of the respective battery module upon receiving the activation signal; and
transmit the measured impedance wirelessly to the first wireless battery management module.

6. The wireless battery management system of any one of claims 1 to 5,
wherein each of the plurality of wireless EIS modules is detachably coupled to a respective one of the plurality of battery modules.

7. A battery pack, comprising:
a plurality of battery modules, each battery module comprising a plurality of battery cells; and
a wireless battery management system configured to manage the plurality of battery modules,
wherein the wireless battery management system comprises:
a plurality of wireless electrochemical impedance spectroscopy (EIS) modules, each wireless EIS module coupled to a respective one of the plurality of battery modules and configured to generate EIS measurement results by measuring EIS of the respective one of the plurality of battery modules; and
a first wireless battery management module communicatively, wirelessly coupled to the plurality of wireless EIS modules and configured to manage the plurality of battery modules based on the EIS measurement results received wirelessly from the plurality of wireless EIS modules.

8. The battery pack of claim 7, further comprising: a plurality of second wireless battery management modules, each second wireless battery management module coupled to a respective one of the plurality of battery modules and configured to monitor and manage a state of the respective battery module.

9. The battery pack of claims 7 or 8, further comprising: a communication module configured to communicate with a battery-powered device configured to operate by receiving power from the battery pack.

10. An apparatus, comprising:
a battery pack comprising a wireless battery management system, wherein the wireless battery management system comprises:
a plurality of wireless electrochemical impedance spectroscopy (EIS) modules, each wireless EIS module coupled to a respective one of a plurality of battery modules included in the battery pack and configured to generate EIS measurement results by measuring EIS of the respective one of the plurality of battery modules; and
a first wireless battery management module communicatively, wirelessly coupled to the plurality of wireless EIS modules and configured to manage the plurality of battery modules based on the EIS measurement results received wirelessly from the plurality of wireless EIS modules;
a communication module configured to communicate with the wireless battery management system included in the battery pack; and
a control module configured to: communicate with the wireless battery management system via the communication module; and control a state of the battery pack.

11. The apparatus of claim 10,
wherein the first wireless battery management module comprises:
a first battery management module configured to manage a state of the plurality of battery modules; and
a first wireless communication module coupled to the first battery management module,
wherein each of the plurality of wireless EIS modules comprises:
an EIS module configured to measure EIS of the respective one of the plurality of battery modules; and
a second wireless communication module coupled to the EIS module and configured to wirelessly communicate with the first wireless communication module.

12. The apparatus of claims 10 or 11,
wherein the wireless battery management system further comprises:
a plurality of second wireless battery management modules, each second wireless battery management module coupled to a respective one of the plurality of battery modules and configured to monitor and manage a state of the respective battery module,
wherein each of the plurality of second wireless battery management modules comprises:
a second battery management module configured to measure and monitor a state of the respective battery module; and
a third wireless communication module coupled to the second battery management module and configured to wirelessly communicate with the first wireless communication module.

13. The apparatus of any one of claims 10 to 12,
wherein the first wireless battery management module is configured to:
wirelessly transmit, to each of the plurality of wireless EIS modules, an activation signal requesting activation of at least one wireless EIS module connected to at least one battery module requiring management; and
wirelessly transmit, to each of the plurality of wireless EIS modules, a deactivation signal upon completion of impedance measurement of the at least one battery module requiring management.

14. The apparatus of claim 13,
wherein each wireless EIS module of the plurality of wireless EIS modules is configured to:
measure impedance of the respective battery module upon receiving the activation signal; and
transmit the measured impedance wirelessly to the first wireless battery management module.

15. The apparatus of any one of claims 10 to 14,
wherein each of the plurality of wireless EIS modules is detachably coupled to a respective one of the plurality of battery modules.
